Europäisches Patentamt

European Patent Office

Office européen des brevets

(19)

(11) Veröffentlichungsnummer: **0 062 761**
**B1**

(12) **EUROPÄISCHE PATENTSCHRIFT**

(45) Veröffentlichungstag der Patentschrift:
**11.06.86**

(21) Anmeldenummer: **82101785.2**

(22) Anmeldetag: **06.03.82**

(51) Int. Cl.⁴: **G 01 S 1/02, G 01 S 1/40,
H 03 C 7/02**

(54) Doppler-Drehfunkfeuer mit einer Überwachungseinrichtung.

(30) Priorität: **10.03.81 DE 3108980**

(43) Veröffentlichungstag der Anmeldung:
**20.10.82 Patentblatt 82/42**

(45) Bekanntmachung des Hinweises auf die Patenterteilung:
**11.06.86 Patentblatt 86/24**

(84) Benannte Vertragsstaaten:
**DE FR GB NL**

(56) Entgegenhaltungen:
**EP - A - 0 034 974
EP - A - 0 045 381
DE - A - 2 505 723
FR - A - 2 347 821
US - A - 3 181 159

ELECTRICAL COMMUNICATION, Band 50, Nr. 4, 1975,
Seiten 245-248, New York, USA G. HOFGEN: "VOR and
Doppler VOR"
ELECTRICAL COMMUNICATION, Band 43, Nr. 2, 1968,
Seiten 143-149, New York, USA W.J. CRONE et al.:
"Doppler VOR ground equipment"**

(73) Patentinhaber: **International Standard Electric
Corporation, 320 Park Avenue, New York New
York 10022 (US)**

(84) Benannte Vertragsstaaten: **FR GB NL**

(73) Patentinhaber: **Standard Elektrik Lorenz
Aktiengesellschaft, Hellmuth-Hirth-Strasse 42,
D-7000 Stuttgart 40 (DE)**

(84) Benannte Vertragsstaaten: **DE**

(72) Erfinder: **Kautz, Werner, Engelbergstrasse 1,
D-7015 Korntal (DE)**

(74) Vertreter: **Graf, Georg Hugo, Dipl.-Ing. et al, c/o
Standard Elektrik Lorenz AG Patent- und Lizenzwesen
Postfach 300 929 Kurze Strasse 8,
D-7000 Stuttgart 30 (DE)**

## Beschreibung

Die Erfindung geht aus von einem Doppler-Drehfunkfeuer (DVOR) mit einer Überwachungseinrichtung wie im Oberbegriff des Anspruchs 1 angegeben. Ein solches Doppler-Drehfunkfeuer ist aus der DE-C- 25 05 723 bekannt.

In der DE-C- 25 05 723 sind zwei Lösungen für eine Einrichtung zur Überwachung der von einer DVOR-Bodenstation abgestrahlten Signale beschrieben.

Bei der einen Lösung werden durch eine geeignete Signalverarbeitung Phasenverschiebungen, die durch unterschiedliche Weglängen von den kreisförmig angeordneten Antennen zu der Überwachungsantenne verursacht werden, kompensiert.

Bei der anderen Lösung wird die Mittelantenne der DVOR-Bodenstation als Überwachungsantenne verwendet. Die von der Überwachungsantenne empfangenen Seitenbänder werden so frequenzmoduliert, daß das frequenzmodulierte Ausgangssignal auch mit der Umlauffreguenz der kreisförmig angeordneten Antennen der DVOR-Bodenstation moduliert ist.

Dies ist notwendig, um ein DVOR-Signal zu erhalten.

Mit beiden Lösungen ist auch im Nahfeld eine korrekte überwachung der abgestrahlten Signale möglich. Die Seitenbandsignale werden bei der Auswertung nicht getrennt verarbeitet.

In der für alle genannten Vertragsstaaten um Stand der Technik gemäß Art. 54 (3) zählenden älteren europäischen Patentanmeldung EP-A- 0 045 381 ist eine Sendeeinrichtung für ein Navigationssystem beschrieben, bei dem zur Regelung von vorgegebenen Phasenbeziehungen zwischen mehreren Signalen einem Mischer einerseits ein Referenzsignal und andererseits nacheinander die Signale, zwischen denen die Phasenbeziehung geregelt werden soll, zugeführt werden. Das Navigationssystem kann ein Doppler-Drehfunkfeuer sein. In diesem Fall sind zwischen der Trägerschwingung des Trägersignals und den Seitenbandsignalen konstante Phasendifferenzen einzuhalten.

Die Erfindung betrifft ebenfalls ein Doppler-Drehfunkfeuer. Wie bereits erwähnt, ist es für eine korrekte Signalabstrahlung besonders wichtig, daß die Phasendifferenzen zwischen Trägersignal und Seitenbandsignale konstant sind.

Es ist Aufgabe der Erfindung, eine weitere Lösung zur Überwachung der Phasenbeziehungen zwischen dem Trägersignal und den Seitenbandsignalen anzugeben.

Die Lösung dieser Aufgabe erfolgt mit den im kennzeichnenden Teil des Anspruchs 1 angegebenen Mitteln. Vorteilhafte Weiterbildungen sind den Unteransprüchen zu entnehmen.

Bei dem neuen Doppler-Drehfunkfeuer mit einer überwachungseinrichtung kann bereits im Nahfeld geprüft werden, ob die Phasenbeziehung zwischen den Trägerschwingungen von Träger- und Seitenbandsignalen korrekt ist. Zur Überwachung dieser Phasenbeziehung sind keine zusätzlichen Überwachungsantennen notwendig.

Man erhält auf Mischerausgangssignale abgebildete Phasendifferenzen, die gleich den Phasendifferenzen im Strahlungsfeld sind, unter anderem deswegen, weil das von den Seitenbandantennen empfangene Trägersignal auf dem Weg von der Antenne zum Koppler denselben Weg durchläuft, wie das Seitenbandsignal.

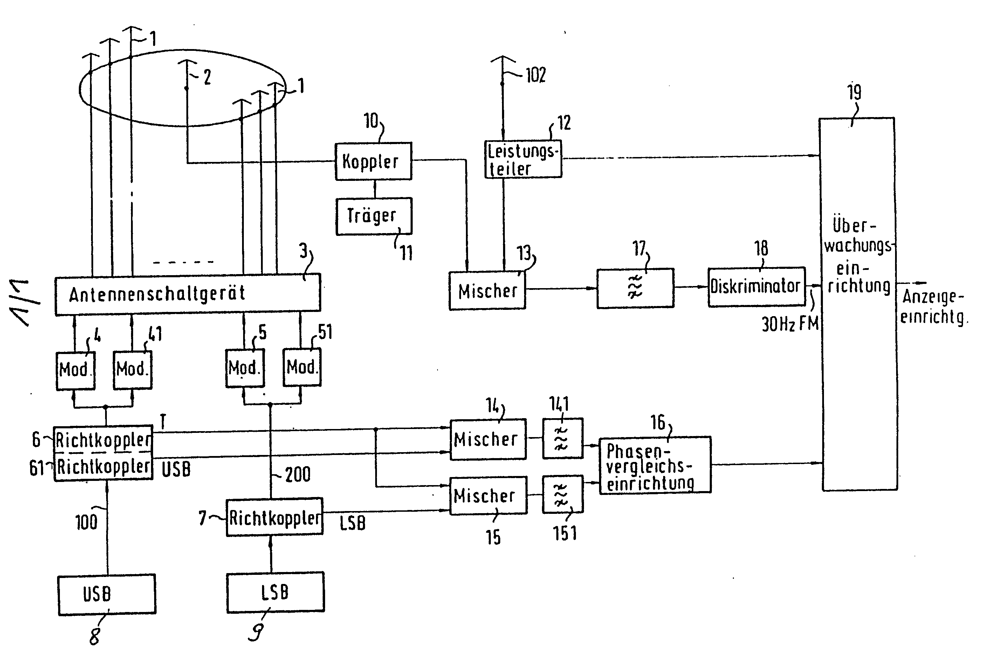

Die Erfindung wird anhand der einzigen Zeichnung, die ein Blockschaltbild mit den zum Verständnis der Erfindung wesentlichen Teilen des neuen Doppler-Drehfunkfeuers ist, beispielsweise näher erläutert.

In der Beschreibung werden die Teile des Doppler-Drehfunkfeuers, nachfolgend mit DVOR abgekürzt, und die Signale und Signalmodulationen, die für die Erfindung ohne Bedeutung sind, nicht berücksichtigt.

Ein in einer Trägersignalquelle 11 erzeugtes Trägersignal wird von einer Trägerantenne 2 und die in Seitenbandsignalquellen 8, 9 erzeugten Seitenbandsignale werden von Seitenbandantennen 1 abgestrahlt. Die Seitenbandantennen sind kreisförmig angeordnet und die Trägerantenne befindet sich im Kreismittelpunkt.

Bei einem Zweiseitenband-DVOR werden die Seitenbandsignale (oberes Seitenband: USB; unteres Seitenband: LSB) den Seitenbandantennen so zugeführt, daß die Bewegungen von zwei Strahlungsquellen, die sich auf dem Kreis gegenüberliegen, simuliert werden. Die eine Strahlungsquelle strahlt das obere und die andere das untere Seitenband ab.

Um zu gewährleisten, daß eine möglichst kontinuierliche Strahlungsquellenbewegung simuliert wird, erfolgt von einer Antenne zu ihrer benachbarten Antenne keine harte Umschaltung, wobei unter harter Umschaltung verstanden wird, daß zunächst die eine und anschließend die andere Antenne wirksam geschaltet ist.

Eine weiche Umschaltung erreicht man dadurch, daß die Seitenbandsignale jeweils zwei benachbarten Antennen zugeführt und die Seitenbandsignale geeignet amplitudenmoduliert werden. Zur Amplitudenmodulation der beiden Seitenbandsignale sind jeweils zwei Amplitudenmodulatoren 4, 41 und 5, 51 vorgesehen.

Das Weiterschalten der Seitenbandsignale von Antenne zu Antenne wird durch ein Antennenschaltgerät 3 bewirkt.

Die bislang beschriebenen Bauteile, ihre Arbeitsweise und ihre Steuerung sind allgemein bekannt und wurden deshalb nur kurz erläutert.

Bei Navigationssendeeinrichtungen ist es besonders wichtig, daß die abgestrahlten Signale ihre vorgeschriebenen Werte einhalten. Deshalb sind Überwachungseinrichtungen vorgesehen, die diese Werte kontinuierlich überwachen.

Bei den von einem DVOR abgestrahlten Navigationssignal muß die Phase der Trägerschwingung des von der Trägerantenne 2 abgestrahlten Trägersignals symmetrisch zwischen den Phasen der Trägerschwingungen der von auf dem Kreis einander gegenüberliegend angeordneten Seitenbandantennen abgestrahlten Seitenbandsignale liegen. Um dies zu überwachen, wird wie nachfolgend beschrieben vorgegangen.

Richtkoppler 61 und 7 koppeln jeweils einen geringen Teil der von den Seitenbandsignalquellen erzeugten Seitenbandsignale aus und führen diese Teile Mischern 14 und 15 zu.

Die Seitenbandantennen 1 strahlen nicht nur die Seitenbandsignale ab sondern empfangen auch das von der Trägerantenne 2 abgestrahlte Trägersignal. Dieses Trägersignal durchläuft die Wege der Seitenbandsignale von den Signalquellen zu den Antennen in umgekehrter Richtung. Entsteht auf dem Weg eines Seitenbandsignals von Signalquelle zur Antenne eine Phasenverschiebung der Trägerschwingung des Seitenbandsignals, dann wird auch das von der Seitenbandantenne empfangene und weitergeleitete Signal um den gleichen Betrag phasenverschoben.

Ein Richtkoppler 6 koppelt aus der Speiseleitung 100 für das obere Seitenbandsignal das von einer Seitenbandantenne 1 empfangene Trägersignal aus und leitet dieses zu den beiden Mischern 14,15. In den Mischern 14,15 werden also das obere Seitenbandsignal mit dem Träger und das untere Seitenbandsignal mit dem Träger gemischt.

Es ist weiterhin möglich, auch in der Speiseleitung 200 für das untere Seitenbandsignal einen weiteren Richtkoppler vorzusehen. In diesem Pall werden die Ausgangssignale der Richtkoppler, die jeweils das Trägersignal auskoppeln, jeweils einem Mischer zugeführt. Die Richtkoppler für die Auskopplung des Trägersignals und des Seitenbandsignals in einer Speiseleitung können auch als bidirektionale Koppler ausgekoppelt sein (ein bidirektionaler Richtkoppler koppelt das Trägersignal und das Seitenbandsignal aus).

Die Ausgangssignale der Mischer sind Signale, deren Frequenz gleich der Frequenzdifferenz von Trägersignal und Seitenbandsignal ist, d.h. bei einem DVOR ist diese Frequenz 9.960 Hz. Die Phasendifferenz zwischen Trägersignal und inem Seitenbandsignal wird (wie sich aus einem Zeigerdiag amm ergibt) auf das Ausgangssignal eines Mischers abgebildet. Die abgebildete Phasendifferenz ist die Phasendifferenz im Strahlungsfeld, weil das zum Mischen verwendete Trägersignal das von der Trägerantenne abgestrahlte Signal und nicht ein direkt vom Trägersender ausgekoppeltes Signal ist und weil das von den Seitenbandantennen empfangene Trägersignal auf dem Weg von der Antenne zum Koppler denselben Weg durchläuft wie das Seitenbandsignal.

Die Ausgangssignale der Mischer 14,15 werden über Filter 141, 151 einer Phasenvergleichseinrichtung 16 zugeführt. Haben die Trägerschwingungen zueinander die vorgeschriebenen Phasenbeziehungen, dann wird in der Phasenvergleichseinrichtung 16 die Phasendifferenz null gemessen. Das Ausgangssignal der Phasenvergleichseinrichtung wird einer Überwachungseinrichtung 19 zugeführt, in der das Meßergebnis der Phasenvergleichseinrichtung mit dem Sollwert, der der Phasendifferenz null entspricht, verglichen wird. Weicht das Meßergebnis so stark vom Sollwert ab, daß es nicht mehr innerhalb der zugelassenen Grenzen liegt, dann erfolgt eine Alarmmeldung in einer Anzeigeeinrichtung.

Bei der Inbetriebnahme der Anlage kann die Anzeige, daß die Phasendifferenz vom Sollwert abweicht, bei der Einstellung der vorgeschriebenen Phasenbeziehungen ausgenutzt werden. Es ist weiterhin möglich (jedoch in der Zeichnung nicht dargestellt), das Doppler-Drehfunkfeuer so zu erweitern, daß die gemessene Phasendifferenz zur Ableitung eines Regelsignals zur Regelung der Phasenbeziehungen verwendet wird.

Zur Überwachung der von dem DVOR abgestrahlten Signale muß unter anderem auch das 30Hz-Modulationssignal wiedergewonnen werden, mit dem die Seitenbandsignale frequenzmoduliert sind.

Hierzu ist in an sich bekannter Weise in einem gewissen Abstand von den Seitenbandantennen 1 ein Felddipol 102 aufgestellt, von dem die von dem DVOR abgestrahlten Signale empfangen werden.

Auf vorteilhafte Weise werden nun einem Mischer 13 das eine Ausgangssignal eines Leistungsteilers 12, der das von dem Felddipol empfangene Signal erhält, und der von einem Koppler 11 ausgekoppelte Teil des Trägersignals zugeführt. Das Mischerausgangssignal wird einem Filter 17, dessen Durchlaßbereich bei 9960 Hz liegt, zugeführt. Das ausgefilterte Signal wird einem Frequenzdiskriminator 18 zugeführt, der das gewünschte 30Hz-Signal, mit dem die Seitenbandsignale frequenzmoduliert sind, abgibt.

Das andere Ausgangssignal des Leistungsteilers 12, das Ausgangssignal des Diskriminators 18 und das Ausgangssignal der Phasenvergleichseinrichtung 16 werden der Überwachungseinrichtung 19 zugeführt, in der auf bekannte Weise die zu überwachenden Parameter überwacht werden.

**Patentansprüche**

1. Doppler-Drehfunkfeuer mit mehreren kreisförmig angeordneten Seitenbandantennen (1) und einer im Kreismittelpunkt angeordneten Trägerantenne (2), bei dem das obere Seitenbandsignal bzw. das untere Seitenbandsignal den Seitenbandantennen von Seitenbandsignalquellen (8, 9) aus über ein Antennenschaltgerät (3) zugeführt werden, und bei dem zur Überwachung der abgestrahlten Signale eine Überwachungseinrichtung (19) vorgesehen ist, dadurch gekennzeichnet, daß ein erster Richtkoppler (61) vorgesehen ist, der einen geringen Teil des oberen Seitenbandsignals (USB) auskoppelt und zu einem ersten Mischer (14) leitet, daß ein zweiter Richtkoppler (7) vorgesehen ist, der einen geringen Teil des unteren Seitenbandsignals (LSB) auskoppelt und zu einem zweiten Mischer (15) leitet, daß mindestens ein weiterer Richtkoppler (6) vorgesehen ist, der das von einer Seitenbandantenne (1) empfangene Trägersignal (T) aus einer Speiseleitung (100) für ein Seitenbandsignal, über die das Trägersignal von der Seitenbandantenne aus weitergeleitet wird, auskoppelt und zu beiden Mischern leitet, daß die Mischerausgangssignale zu einer Phasenvergleichseinrichtung (16), in der die Phasendifferenz zwischen den Mischerausgangssignalen ermittelt wird, weitergeleitet werden, und daß die Überwachungseinrichtung (19) Mittel zur Bestimmung der Abweichung der Phasendifferenz von einem Sollwert aufweist.

2. Doppler-Drehfunkfeuer nach Anspruch 1, dadurch gekennzeichnet, daß das Doppler-Drehfunkfeuer beim Vorhandensein einer Störung abgeschaltet wird.

3. Doppler-Drehfunkfeuer nach Anspruch 1, dadurch gekennzeichnet, daß die Auskopplung (6, 7) der Seitenbandsignale bereits vor ihrer Zuführung zum Antennenschaltgerät (3) erfolgt.

4. Doppler-Drehfunkfeuer nach Anspruch 1, Anspruch 2 oder Anspruch 3, dadurch gekennzeichnet, daß die Auskopplung (6, 7) des Trägersignals erst dann erfolgt, wenn es das Antennenschaltgerät (3) durchlaufen hat.

5. Doppler-Drehfunkfeuer nach einem der Ansprüche 1 bis 4, dadurch gekennzeichnet, daß zur Auskopplung der Trägersignale in zwei Speiseleitungen für Seitenbandsignale jeweils ein Richtkoppler vorgesehen ist und daß das Ausgangssignal des einen Richtkopplers dem ersten Mischer und das Ausgangssignal des anderen Richtkopplers dem zweiten Mischer zugeführt wird.

6. Doppler-Drehfunkfeuer nach Anspruch 5, dadurch gekennzeichnet, daß jeweils ein Richtkoppler zur Auskopplung des Trägersignals und ein Richtkoppler zur Auskopplung eines geringen Teils eines Seitenbandsignals zusammengefaßt sind zu einem bidirektionalen Koppler.

7. Doppler-Drehfunkfeuer nach einem der vorhergehenden Ansprüche, dadurch gekennzeichnet, daß eine Regeleinrichtung zur Regelung der Phase der Trägerschwingung des Trägersignals oder des unteren Seitenbandsignals oder des oberen Seitenbandsignals abhängig von der bestimmten Abweichung der Phasendifferenz auf eine für die Trägerschwingungen dieser Signale vorgeschriebene Phasenbeziehung vorgesehen ist.

## Claims

1. Doppler VOR comprising a circular array of sideband antennas (1) and a carrier antenna (2) located at the centre of the circle, wherein the upper sideband signal and the lower sideband signal are applied from the sideband-signal sources (8,9) to the sideband antennas via an antenna-switching device (3) and wherein a monitoring device (19) is provided for monitoring the radiated signals,

characterised in that a first directional coupler (61) is provided which couples out a small part of the upper sideband signal (USB) and passes it to a first mixer (14), that a second directional coupler (7) is provided which couples out a small part of the lower sideband signal (LSB) and passes it to a second mixer (15), that at least one additional directional coupler (6) is provided which couples out the carrier signal (T) received by a sideband antenna (1) out of a feeder (100) for one of the sideband signals, via which the carrier signal is transferred from the sideband antenna, and applies it to both mixers, that the mixer output signals are passed on to a phase comparator (16) which determines the phase difference between the mixer output signals, and that the monitoring device (19) contains means for determining the deviation of the phase difference from a desired value.

2. A Doppler VOR as claimed in Claim 1, characterised in that, if there is an error, the Doppler VOR is turned off.

3. A Doppler VOR as claimed in Claim 1, characterised in that the coupling out (6,7) of the sideband signals takes place before they are applied to the antenna-switching device (3).

4. A Doppler VOR as claimed in Claim 1, 2 or 3, characterised in that the coupling out (6,7) of the carrier signal does not take place until it has passed through the antenna-switching device (3).

5. A Doppler VOR as claimed in any one of Claims 1 to 4, characterised in that, for coupling out the carrier signals, two sideband-signal feeders include one directional coupler each, and that the output signal of one of the directional couplers is applied to the first mixer and the output signal of the other directional coupler is applied to the second mixer.

6. A Doppler VOR as claimed in Claim 5, characterised in that a directional coupler for coupling out the carrier signal and a directional coupler for coupling out a small part of a sideband signal are combined to form a bidirectional coupler.

7. A Doppler VOR as claimed in any one of the preceding claims, characterised in that a regulating device is provided for regulating the phase of the carrier wave of the carrier signal or of the lower sideband signal or of the upper sideband signal, depending on the determined deviation of the phase difference, to a prescribed phase relationship for the carrier waves of these signals.

## Revendications

1. Balise VOR Doppler comprenant un arrangement circulaire d'antennes de bandes latérales (1) et une antenne d'onde porteuse (2) située au centre du cercle, dans laquelle le signal de bande latérale supérieure et le signal de bande latérale inférieure sont appliqués à partir des sources de bandes latérales (8,9) aux antennes de bandes latérales par l'intermédiaire d'un commutateur d'antennes (3) et dans laquelle un équipement de supervision (19) est prévu pour la surveillance des signaux rayonnés, caractérisée en ce que un premier coupleur directionnel (61) est prévu pour extraire une petite partie du signal de bande latérale supérieure (USB) et la transmettre à un premier mélangeur (14), en ce qu'un second coupleur directionnel (7) est prévu pour extraire une petite partie du signal de bande latérale inférieure (LSB) et la transmettre à un second mélangeur (15), en ce qu'au moins un coupleur directionnel additionnel (6) est prévu pour coupler le signal d'onde porteuse (T) reçu par une antenne de bande laterale (1) à partir de la ligne d'alimentation (100) de l'un des signaux de bande latérale et tranférer ce signal d'onde porteuse de l'antenne vers les deux mélangeurs, en ce que les signaux de sortie des deux mélangeurs sont transmis à un comparateur de phase (16) déterminant la différence de phase entre les signaux de sortie des mélangeurs et en ce que l'équipement de supervision (19) comprend des moyens pour déterminer l'écart de la difference de phase par rapport à une valeur désirée.

2. Balise VOR Doppler selon la revendication 1, caractérisée en ce qu'en présence d'une erreur, la balise est mise hors service.

3. Balise VOR Doppler selon la revendication 1, caractérisée en ce que les signaux de bandes laterales sont extraits (61, 7) avant d'être fournis au commutateur l'antennes (3).

4. Balise VOR Doppler selon l'une des revendications 1 à 3, caractérisée en ce que l'extraction du signal d'onde porteuse a lieu seulement après qu'il ait travesé ledit commutateur d'antenne (3).

5. Balise VOR Doppler selon l'une des revendications 1, 2 ou 3, caractérisé en ce que, pour l'extraction des signaux d'onde porteuse, deux lignes d'alimentation de signal de bande latérale comportent chacune un coupleur directionnel et en ce que le signal de sortie de l'un de ces coupleurs directionnels est appliqué au premier mélangeur, tandis que le signal de sortie de l'autre coupleur directionnel est appliqué au second mélangeur.

6. Balise VOR Doppler selon la revendication 5 caractérisée en ce qu'un coupleur directionnel pour l'extraction du signal d'onde porteuse et un coupleur directionnel pour l'extraction d'une petite partie d'un signal de bande latérale sont combines sous la forme d'un coupleur bidirectionnel.

7. Balise VOR Doppler selon l'une quelconque des revendications precédentes caractérisée en ce qu'un équipement de réglage est prévu pour le réglage de la phase de l'oscillation de l'onde porteuse de la bande latérale inférieure ou de la bande latérale supérieure, en réponse à une déviation déterminée de la différence de phase, sur une relation de phase prescrite pour les oscillations de ces signaux.

1/1